(19)

Europäisches Patentamt
European Patent Office
Office européen des brevets

(11) **EP 4 509 857 A1**

(12) **EUROPEAN PATENT APPLICATION**

(43) Date of publication:
**19.02.2025 Bulletin 2025/08**

(21) Application number: **23191228.8**

(22) Date of filing: **14.08.2023**

(51) International Patent Classification (IPC):
**G01R 31/64** (2020.01)   **G01R 27/26** (2006.01)
G01R 31/26 (2020.01)   G01R 31/40 (2020.01)
G01R 31/44 (2020.01)   H05B 45/30 (2020.01)
H05B 45/50 (2022.01)   H02J 9/06 (2006.01)
H05B 47/17 (2020.01)

(52) Cooperative Patent Classification (CPC):
**G01R 31/64; G01R 27/2605;** G01R 31/2635;
G01R 31/40; G01R 31/44; H02J 9/065; H05B 45/30;
H05B 45/50; H05B 47/172

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Tridonic GmbH & Co. KG
6851 Dornbirn (AT)**

(72) Inventors:
• **Shukla, Jagjitpati
  6850 Dornbirn (AT)**
• **Stephen, James
  6850 Dornbirn (AT)**

(74) Representative: **Rupp, Christian
  Mitscherlich PartmbB
  Patent- und Rechtsanwälte
  Karlstraße 7
  80333 München (DE)**

(54) **ASSESSING A REMAINING LIFETIME OF A LED GEAR**

(57)      The invention relates to a method (10) for assessing a remaining lifetime of an LED gear (20). The method (10) comprises the steps of: supplying (11) a constant current load from an electrolytic capacitor (21) of the LED gear (20); measuring (12) an electrical characteristic of the electrolytic capacitor (21) over time when the constant current load is supplied by the electrolytic capacitor (21); calculating (13) a capacitance of the electrolytic capacitor (21) based on the measured electrical characteristic; and determining (15) a remaining lifetime estimate and/or a reaching of an end of lifetime of the LED gear (20) based on the calculated capacitance.

Fig. 1

EP 4 509 857 A1

**Description**

TECHNICAL FIELD OF THE INVENTION

The invention is in the field of assessing the health and, in particular, a remaining lifetime of an LED gear, such as an emergency lighting LED driver.

BACKGROUND OF THE INVENTION

The expected lifetime of a LED gear, such as an LED driver, is limited by the lifetime of its internal components. Most power electronic converters utilize aluminum electrolytic capacitors (short: ELCAPs or ECAPs) in their power stage design. For example, in an emergency lighting LED driver, aluminum ELCAPs are often used in the frontend AC-DC and DC-DC stages. These ELCAPs are generally considered as the weakest elements in the power electronics design and are normally bound to fail first compared to other components of the driver.

Since the lifetime of an ELCAP typically correlates with its temperature during operation, it is known, to estimate the remaining lifetime of an emergency lighting LED driver based on the temperature of its ELCAP during operation. The ELCAP temperature is e.g. derived from a known control gear temperature, e.g. a temperature of a micro controller or an ASIC of the LED driver.

However, the estimated ELCAP temperature might deviate somewhat from its actual temperature, which could influence the resulting lifetime estimate. For instance, a formula that correlates the ELCAP temperature with the control gear temperature is usually derived from a model training routine, which might not accurately reflect the field operating conditions.

Thus, it is an objective of the invention to provide an improved method for assessing a remaining lifetime of an LED gear as well as an improved LED gear, which avoid the above-mentioned disadvantages.

SUMMARY OF THE INVENTION

The object of the present invention is achieved by the solution provided in the enclosed independent claims. Advantageous implementations of the present invention are further defined in the dependent claims.

According to a first aspect, the invention relates to a method for assessing a remaining lifetime of an LED gear. The method comprising the steps of: supplying a constant current load from an electrolytic capacitor of the LED gear; measuring an electrical characteristic of the electrolytic capacitor over time when the constant current load is supplied by the electrolytic capacitor; calculating a capacitance of the electrolytic capacitor based on the measured electrical characteristic; and determining a remaining lifetime estimate and/or a reaching of an end of lifetime of the LED gear based on the calculated capacitance.

This achieves the advantage that the remaining lifetime and/or the end of lifetime of the LED gear can be accurately determined based on a measurement of electrical characteristics of its electrolytic capacitor. The electrolytic capacitor can be the component of the LED gear which mainly defines (i.e., limits) the lifetime of the LED gear.

In particular, the remaining lifetime / end of lifetime is thereby determined based on a direct capacitance measurement of the electrolytic capacitor (ELCAP). In general, the capacitance of the ELCAP reduces over time when the ELCAP ages, which makes it a good measure for the degree of degradation of the ELCAP. Thus, the remaining lifetime of the ELCAP (and thus the LED gear) can be determined based on a decrease of its capacitance.

Here, the remaining lifetime estimate of the LED gear may refer to a remaining operating lifetime or service life during which a proper function of the LED gear can be expected. The remaining lifetime estimate can be expressed by the number of remaining operating hours, e.g., 20,000 h, for which the proper function is expected. For instance, when the end of lifetime is reached, the remaining lifetime is zero.

The LED gear can be an LED driver, in particular an emergency lighting LED driver or can comprise such an LED driver.

For instance, the electrolytic capacitor is an aluminum electrolytic capacitor of the LED gear.

In particular, the constant current load is a load which approximately draws a constant current regardless of the voltage. The constant current load can be an internal component of the LED gear. The electrolytic capacitor can supply the constant current load with a (constant) load current.

Preferably, the load current that is drawn by the constant current load is known. Thus, no sensor is required to sense the load current.

For instance, when measuring the electrical characteristic, the constant current load is only supplied from the electrolytic capacitor and is the only load on the electrolytic capacitor.

In an embodiment, the electrical characteristic is a, preferably linear, voltage drop across the electrolytic capacitor.

The voltage drop can be caused by a, preferably linear, discharge of the ELCAP while it supplies the constant current load.

The capacitor voltage may fall in a linear fashion due to the constant current loading. The capacitance calculation can be performed in the same and/or a single discharge cycle of the electrolytic capacitor. In particular, the calculation of the capacitance does not require an initial value of the capacitance (e.g., from a datasheet) as a parameter.

In an embodiment, the constant current load is supplied from the electrolytic capacitor for a defined time period; and the capacitance is calculated based on a gradient of the voltage drop during the time period.

For instance, the sharper the voltage drop during the time period, the lower the capacitance of the ELCAP and the shorter the remaining lifetime. The voltage can be sampled during the time period.

In an embodiment, the reaching of the end of lifetime is detected when the calculated capacitance of the electrolytic capacitor falls below a threshold value.

The threshold value can be defined as a reduction of an initial ELCAP capacitance by a certain percentage value, e.g. a 10% loss of its initial capacitance. This initial value of the ELCAP capacitance can be calculated in the same way as a current capacitance (e.g., when performing a first capacitance measurement after commissioning the LED gear).

In an embodiment, the constant current load is supplied from the electrolytic capacitor in, preferably regular, time intervals; wherein, each time the constant current load is supplied from the electrolytic capacitor, the electrical characteristic over time of the electrolytic capacitor is measured and a respective capacitance is calculated based on each measured electrical characteristic.

In an embodiment, the remaining lifetime estimate is determined based on a difference of at least two subsequently calculated capacitances.

Alternatively or additionally, an average capacitance of the ELCAP can be determined from a number of subsequent capacitance measurements. This average capacitance can be compared to an initial capacitance or a previously calculated capacitance (or an average of these values) to determine the remaining lifetime estimate of the ELCAP.

In an embodiment, the method comprises the further step of: determining an aging rate, in particular an average aging rate, of the electrolytic capacitor based on a change of the calculated capacitances over time.

For instance, the remaining lifetime estimate of the LED gar can be determined based on said "aging rate" of the ELCAP. For example, the remaining lifetime estimate can be extrapolated from the aging rate.

In an embodiment, the constant current load is supplied from the electrolytic capacitor each time a function test of the LED gear is carried out.

This achieves the advantage that the estimation of the remaining lifetime can be integrated in a scheduled event or operating mode of the LED gear, namely the function test. The function test can be a specific mode of operation of the LED gear, during which it is tested if the LED gear functions properly. The function test can be carried out in regular time intervals, e.g. once per week or n-times per month. The function test, thus, provides a clear starting point for starting the lifetime assessment.

In particular, the capacitance of the ELCAP is calculated each time the function test is carried out.

The starting point of the linear discharge of the electrolytic capacitor can be synchronized with the start of the function test.

In an embodiment pertaining to emergency LED, during the function test, the step of measuring the electrical characteristic of the electrolytic capacitor is carried out after disconnecting the mains-supplied AC-DC converter/PFC supply of the emergency LED gear and prior to powering connected LEDs off a battery of the emergency LED gear.

For instance, disconnecting the PFC supply and powering the LEDs off the battery is a typical routine that is performed during the function test, especially of an emergency lighting LED driver. With PFC supply disconnected and not operating the battery charger, the powering of LEDs off the battery is delayed for a specified lifetime test window, so that the microcontroller (i.e., the constant current load) is the only load on the ELCAP. Thus, the electrolytic capacitor remains temporarily isolated from the circuit arrangement when supplying the constant current load during the function test.

In an embodiment, during the measurement of the electrical characteristic, the constant current load is the only current load supplied by the electrolytic capacitor.

For instance, all other possible loads on the ELCAP as well as the AC/DC or DC/DC power supply source are switched off and/or disconnected from the ELCAP for the time during which the electrical characteristic is measured.

In an embodiment, the constant current load is a microcontroller of the LED gear.

According to a second aspect, the invention relates to an LED gear, in particular an emergency lighting LED driver. The LED gear comprises: an electrolytic capacitor which is configured to supply a constant current load; and a controller which is configured to measure an electrical characteristic of the electrolytic capacitor over time when the constant current load is supplied by the electrolytic capacitor; wherein the controller is configured to calculate a capacitance of the electrolytic capacitor based on the measured electrical characteristic; and wherein the controller is configured to determine a remaining lifetime estimate and/or a reaching of an end of lifetime of the LED gear based on the calculated capacitance.

The LED gear can be connected to an LED load, e.g. an emergency (EM) luminaire, and can be configured to electrically supply the LED load.

The LED gear can be connected to a mains supply for receiving electrical power. The LED gear can further be connected to a battery (or can comprise a battery), which can be used for a temporal power supply of the LED load during a mains power outage.

The LED gear can comprise more than one electrolytic capacitors.

In an embodiment, the electrical characteristic is a, preferably linear, voltage drop across the electrolytic capacitor.

In an embodiment, the controller is configured to detect the reaching of the end of lifetime when the calculated capacitance of the electrolytic capacitor falls below a threshold value.

In an embodiment, the electrolytic capacitor is configured to supply the constant current load in, preferably regular, time intervals; wherein, each time the constant current load is supplied from the electrolytic capacitor, the controller is configured to measure the electrical characteristic of the electrolytic capacitor over time and to calculate a respective capacitance based on each measured electrical characteristic. In an embodiment, the controller is configured to calculate the remaining lifetime estimate based on a difference of at least two subsequently calculated capacitances.

In an embodiment, the LED gear further comprises an optical indicator which is configured to display a signal when the reaching of the end of lifetime is detected.

For example, the optical indicator can be an indicator LED. The signal can be a flashing of the LED.

In an embodiment, the constant current load is a microcontroller of the LED gear.

The controller and the microcontroller of the LED gear can be identical or separate units. Thus, the microcontroller used as constant current load may be the same controller which calculates the capacitance and controls the switches in the LED driver. However, it is also possible that the constant current load on the capacitor is implemented by a separate dedicated constant current load circuit for this purpose and the microcontroller would be controlling this constant current load circuit and doing the calculations.

In an embodiment, the LED gear further comprises: a communication interface configured to output the calculated capacitance and/or the determined remaining lifetime estimate.

For instance, the communication interface can be a DALI interface.

The calculated capacitance and/or the determined remaining lifetime estimate can be output to an external computing device (e.g., a computer or server) which is connected to the communication interface, e.g., via a communication network.

The LED gear according to the second aspect of the invention can be adapted to carry out the method of the first aspect of the invention.

BRIEF DESCRIPTION OF THE DRAWINGS

The invention will be explained in the followings together with the figures.

Fig. 1     shows steps of a method for assessing a remaining lifetime of an LED gear according to an embodiment;

Fig. 2     shows a schematic diagram of an LED gear according to an embodiment;

Fig. 3     shows a schematic diagram of an LED gear according to an embodiment;

Fig. 4     shows a schematic diagram of an LED gear according to an embodiment;

Fig. 5     shows different of parameters of an LED gear over time according to an embodiment;

Fig. 6     shows different of parameters of an LED gear over time according to an embodiment; and

Fig. 7     shows a flow chart of an operating procedure for lifetime assessment of an LED gear according to an embodiment.

DETAILED DESCRIPTION OF THE PREFERRED EMBODIMENTS

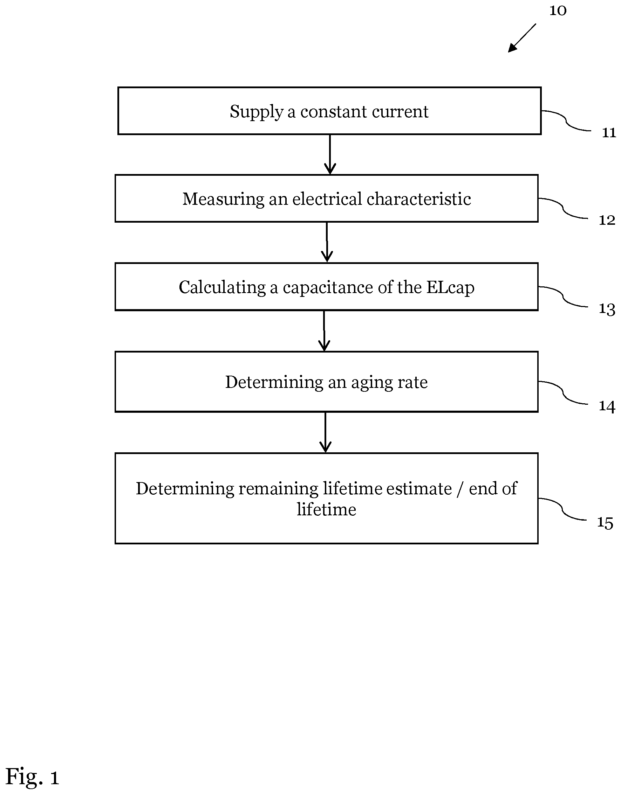

Fig. 1 shows steps of a method 10 for assessing a remaining lifetime of an LED gear according to an embodiment.

The method 10 comprises the steps of: supplying 11 a constant current load from an electrolytic capacitor of the LED gear; measuring 12 an electrical characteristic of the electrolytic capacitor over time when the constant current load is supplied 11 by the electrolytic capacitor; calculating 13 a capacitance of the electrolytic capacitor based on the measured 12 electrical characteristic; and determining 15 a remaining lifetime estimate and/or a reaching of an end of lifetime of the LED gear based on the calculated capacitance.

Typically, the electrolytic capacitor (ELCAP) is the electronic component of the LED gear which fails first. Thus, the lifetime of the ELCAP limits the overall lifetime of the LED gear. The absolute value of the capacitance of the ELCAP thereby degrades or reduces over time as the ELCAP ages. This gradual reduction of the capacitance of the ELCAP can be used as a parameter for determining/calculating the expected remaining lifetime and reaching of the end of lifetime of the LED gear.

The constant current load can be a microcontroller of the LED gear. Typical, the microcontroller consumption current is approximately constant over its operating temperature range. The constant current load being supplied 11 from the ELCAP may refer to the constant current load being connected to the ELCAP and the ELCAP providing a constant load current to the constant current load (i.e., the ELCAP is discharged into the constant current load).

Preferably, when measuring the electrical characteristic, the electrolytic capacitor only supplies the constant current load. For instance, all other potential current sources and loads are switched off or disconnected from the constant current load and/or the electrolytic capacitor during the time periods when the electrical characteristic is measured.

The electrolytic capacitor (ELCAP) can be an aluminum ELCAP.

For instance, the correlation between a reduction in the ELCAP capacitance and the (expected) remaining operating hours of the ELCAP is known (e.g., from the ELCAP manufacturer). For example, after 12,000 operating hours, the capacitance of an ELCAP can drop by more than 5% (e.g., from ca. 9.5 to ca. 9.0 $\mu$F). This knowledge can be used for determining 15 the remaining lifetime estimate from the calculated capacitance values.

The constant current load can be supplied 11 from the electrolytic capacitor in, preferably regular, time intervals (e.g. each time a function test of the LED gear is carried out). Thereby, each time the constant current load is supplied 11 from the electrolytic capacitor, the electrical characteristic over time can be measured and a respective capacitance can be directly calculated 13 based on each measured electrical characteristic.

For example, the remaining lifetime estimate can then be determined based on a difference, in particular a decrease, of the calculated capacitances between at least two subsequent measurements. This change of the capacitance over time can represent an "aging" or "aging rate" of the ELCAP.

As such, the method 10 may further comprise the optional step of: determining 14 an aging rate, in particular an average aging rate, of the electrolytic capacitor based on a change of the calculated capacitances over time. For example, the remaining lifetime estimate can be extrapolated from the aging rate.

The reaching of the end of lifetime of the LED gear can be determined 15 when the calculated capacitance has dropped below a threshold value.

For example, the threshold value can be defined based on the known correlation between the ELCAP capacitance and the remaining operating hours. For example, a 20% reduction in the capacitance value compared to a starting point (i.e., an initial capacitance) can be used as the threshold to flag that the LED gear (and the ELCAP itself) has reached its end of life and should be replace by a new unit.

The initial capacitance could be determined by one or more initial capacitance measurements and an optional averaging. Alternatively, the initial capacitance may be known from the manufacturer.

The LED gear, e.g. an emergency LED driver, can comprise more than one ELCAP. However, for the lifetime prediction assessment any one suitable ELCAP of the LED gear can be used for estimating the remaining lifetime of the LED gear.

For instance, the remaining lifetime of all remaining ELCAPs of the LED gear can be derived from the remaining lifetime of a single, selected ELCAP based on a known correlation of the ELCAP lifetimes. For example, if the capacitance / remaining lifetime of the selected ELCAP reaches a threshold (e.g., 50% of its end of life time), a different ELCAP of the LED gear can reach its end of life time at the same time. Hence, an alarm can be raised when the selected ELCAP falls below 50% of its remaining lifetime. For example, this can be theoretically and/or experimentally confirmed beforehand based on lifetime calculation formulas and experimentation. Hence, it can be sufficient to use only one ELCAP of the LED gear for the remaining lifetime assessment. This "selected" ELCAP is not necessarily the ELCAP with the shortest lifetime.

The electrical characteristic can be a voltage drop across the ELCAP while the ELCAP supplies the constant current load (i.e., while the electrolytic capacitor is discharged into the constant current load). In particular, the electrical characteristic is a linear voltage drop.

The constant current load can be supplied from the electrolytic capacitor for defined time periods (of e.g. 100 ms or less). During each of these time periods, the capacitance of the ELCAP can be calculated based on a gradient of the voltage drop. The gradient can be a time gradient (i.e., a change of the voltage drop over time). In particular, during each of these time periods, the constant current load is only supplied from the electrolytic capacitor.

The capacitance values of the chosen ELCAP can be calculated in real time by sampling the voltage drop during the defined time period. For example, the voltage drop is measured at the start and at the end of each time period. These two measurements of the voltage drop can be used to calculate a respective capacitance value.

For example, during linear discharge of the ELCAP, two samples (start and end) of its voltage are measured based on following condition (whichever occurs first): The capacitor voltage falls by a certain amount (e.g., 1 V or 1.5 V) and a maximum sample time of 100 ms is passed. The capacitance of the ELCAP can be calculated based on the sampled voltages, the known linear discharge current (load current) and the time that is required for the voltage across the capacitor to drop for the certain amount.

The steps of the method 10 can be carried out whenever the emergency LED gear performs a so-called 'function test'. Typically, during a function test of an LED gear (such as an emergency lighting LED driver) the PFC supply to the LED gear is disconnected and the connected LEDs are powered off a battery of the LED gear or a battery that is connected to the LED gear. Usually, the function test is performed more frequently than a full duration test. For instance, the function test is performed once every week. Hence, the function test provides a good opportunity to check the health of an ELCAP of the LED gear.

The function test typically comprises a temporary disconnection of the PFC supply of the LED gear and a powering of a connected LED load off a battery. The step of measuring 12 the electrical characteristic of the electrolytic capacitor can be carried out in-between these two steps. In particular, the electrical characteristic is measured at a time when the load is only supplied from the electrolytic capacitor and all other possible current sources are disconnected.

The constant current load can be a microcontroller of the LED gear.

In particular, due to the microcontroller drawing a known, constant current, no sensor is required to measure the ELCAP discharge current.

For monitoring purposes, the calculated value of the capacitance of the ELCAP can be transmitted via a communication connection, e.g. via a DALI connection, to an external device (e.g., a central controller or server). In an example, a new capacitance value is provided each time a function test is performed by the emergency LED driver.

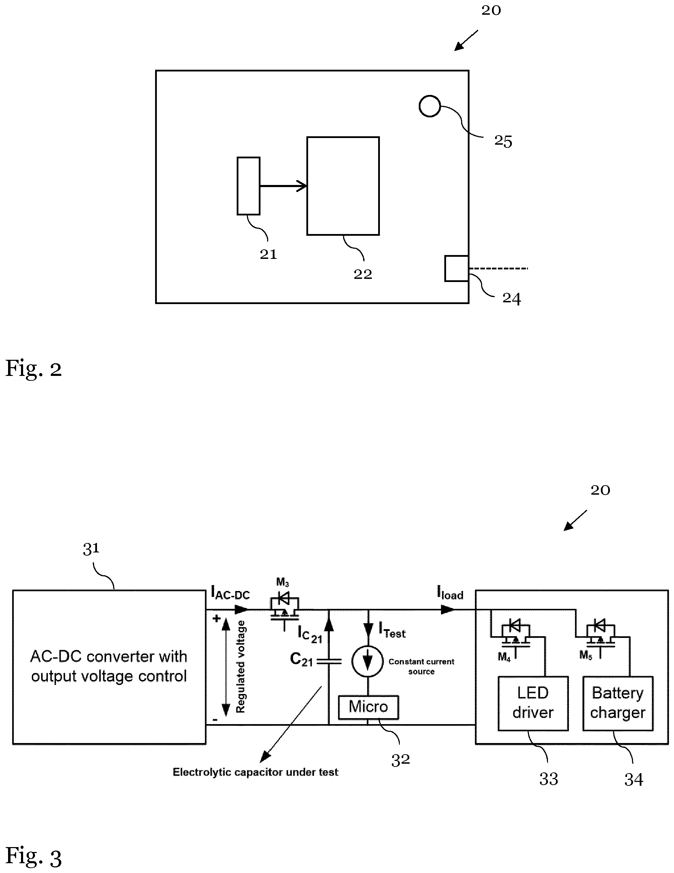

Fig. 2 shows a schematic diagram of the LED gear 20 according to an embodiment. The LED gear 20 can be configured to carry out the steps of the method 10 as shown in Fig. 1.

The LED gear 20 comprises the electrolytic capacitor 21 which is configured to supply the constant current load. The LED gear 20 further comprises a controller 22 which is configured to measure the electrical characteristic of the electrolytic capacitor 21 over time when the constant current load is supplied by the electrolytic capacitor 21; wherein the controller 22 is further configured to calculate a respective capacitance of the electrolytic capacitor 21 based on the measured electrical characteristic; and wherein the controller 22 is configured to determine a remaining lifetime estimate and/or a reaching of an end of lifetime of the LED gear 20 based on the calculated capacitance.

The controller 22 can be configured to measure the electrical characteristic in the form of a, preferably linear, voltage drop across the electrolytic capacitor 21 during the linear current discharge of the electrolytic capacitor 21.

The electrolytic capacitor 21 can supply the constant current load in regular time intervals, wherein the controller is configured to measure the electrical characteristic and calculate a respective capacitance of the electrolytic capacitor 21, each time the constant current load is supplied by the electrolytic capacitor 21.

For instance, the controller 22 can be configured to calculate the remaining lifetime estimate based on the difference of at least two subsequently calculated capacitances. In addition, the controller 22 can calculate an aging rate of the electrolytic capacitor 21 and/or the LED gear 20 based on a change of the calculated capacitance over time.

The controller 22 can further be configured to determine the reaching of the end of lifetime of the LED gear 20 when the calculated capacitance of the electrolytic capacitor 21 falls below the threshold value.

As shown in Fig. 2, the LED gear 20 may comprise an optical indicator 25, e.g. a status LED, which is configured to display a signal when the reaching of the end of lifetime is detected.

The LED gear 20 may further comprise a wire-bound or wireless interface 24, e.g. a DALI interface, which is configured to output the calculated capacitance values and/or the determined remaining lifetime estimate, e.g., to external device such as a central controller or server.

The constant current load can be a microcontroller of the LED gear 20. For example, this microcontroller and the controller 22 can be identical.

Fig. 3 shows a schematic diagram of the LED gear 20. For example, the LED gear 20 is an LED driver, in particular an emergency lighting LED driver.

As shown in Fig. 3, the LED gear 20 can comprise an AC-DC converter 31, which provides a regulated DC current $I_{AC-DC}$. The LED gear 20 can further comprise the electrolytic capacitor C21, the microcontroller 32 and a battery charger 34, which is connected to an internal or external battery. These components can be connected via one or more switches M3, M4, M5.

To measure the capacitance of the ELCAP 21, the controller of the LED gear 20 (e.g., the microcontroller 32 itself) can connect the ELCAP $C_{21}$ with the microcontroller 32, which acts as a constant current load. At the same time, the controller can interrupt all other current supplies from the microcontroller 32, such that the microcontroller 32 is only supplied with a load current $I_{C21}$ from the ELCAP 21 and no other load is supplied from the ELCAP 21. This can be done, by opening the switches M3 and M5, e.g. during a function test of the LED gear 20.

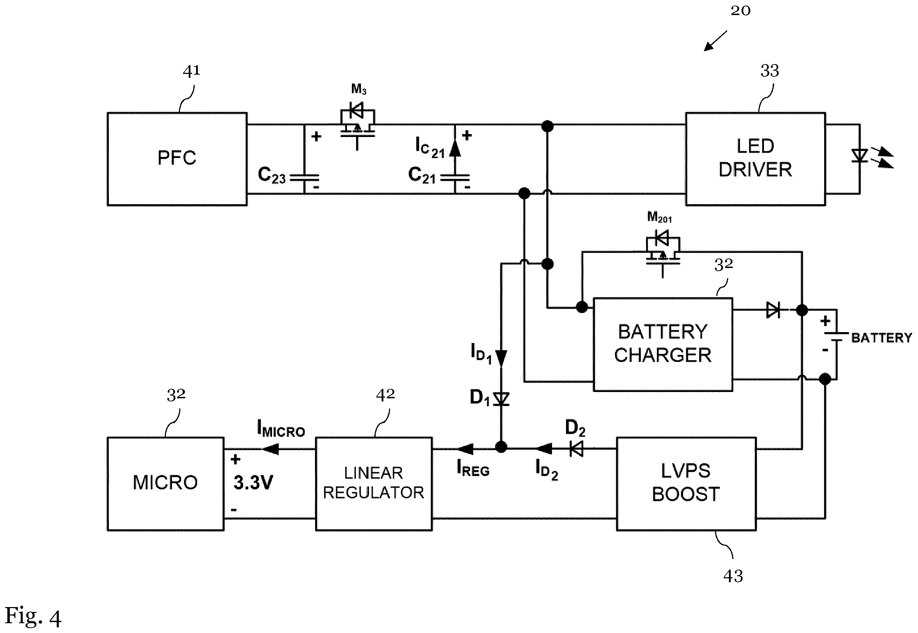

Fig. 4 shows a further schematic diagram of the LED gear 20 according to an embodiment.

As shown in Fig. 4, the LED gear 20 may comprise a PFC stage 41, which is connected to the LED driver 33 via

two ELCAPs $C_{23}$, $C_{21}$. For instance, the capacitance of ELCAP $C_{21}$ is used to assess the remaining lifetime of the LED gear 20.

The LED gear 20 can further be connected to a battery supply, e.g., via the battery charger 34, and may comprise a boost low voltage power supply (LVPS) 43, a liner regulator 42 and the microcontroller 32. Again, the microcontroller 32 can form the constant current load.

To calculate the capacitance of the ELCAP $C_{21}$, the switches $M_3$, $M_{201}$ can be controlled to prevent a powering of the microcontroller 32 from the PFC and the battery for a certain time period, such that in this time period the microcontroller 32 is only charged via a load current $I_{C21}$ from the ELCAP $C_{21}$.

The measurement of the capacitance of the ELCAP $C_{21}$ can be carried out during a function test of the LED gear 20.

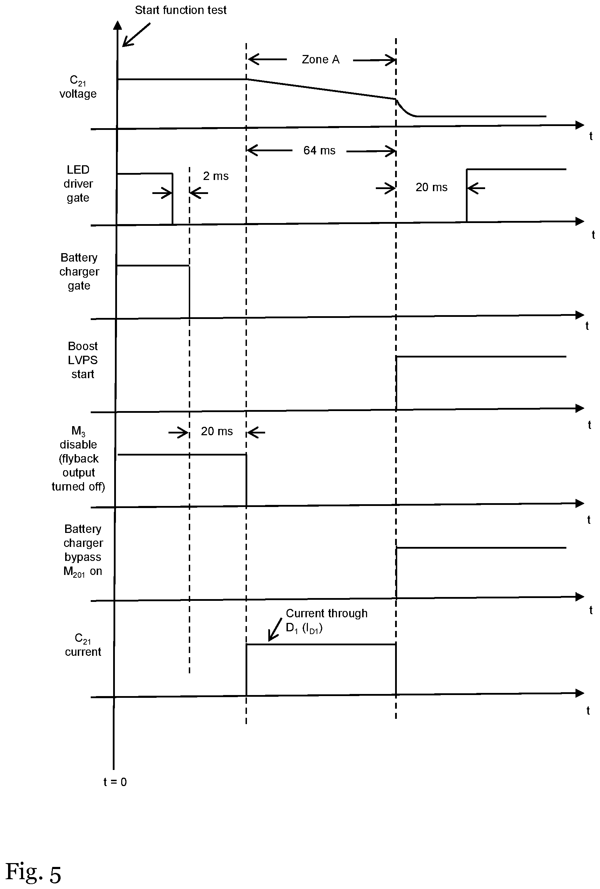

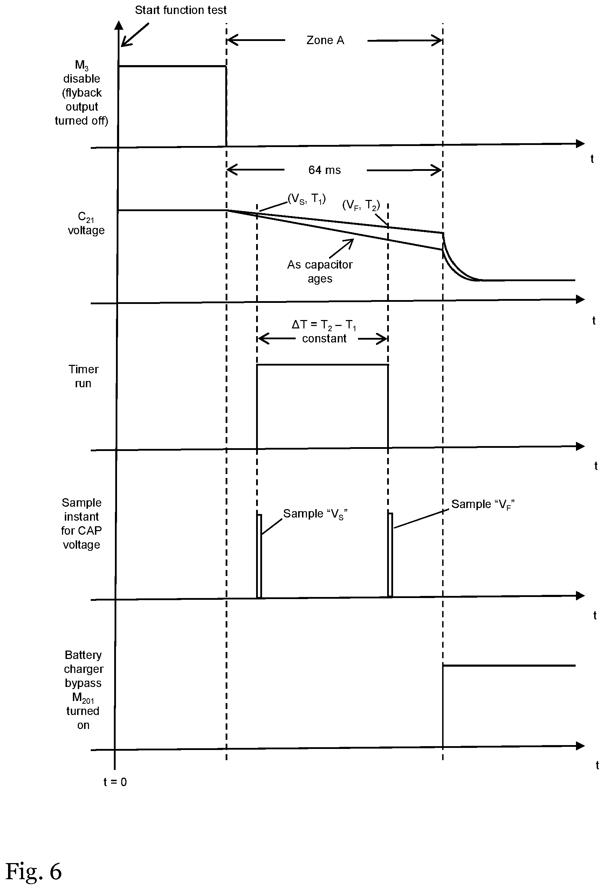

Figs. 5 and 6 show examples of different parameters of the LED gear 20, as shown in Fig. 4, over time during such a function test. For instance, when the function test is triggered the following sequence of events may occur in chronological order in the LED gear 20:

a) The LED driver 33 is turned off.
b) The battery charger 34 is turned off a short time (e.g., 2m s) after the LED driver 33 is turned off.
c) The switch M3 is turned off a short time (e.g., 12 ms) after the battery charger is turned off. This disables an output of the flyback PFC 41 and the capacitor $C_{21}$ is free to discharge.
d) The switch $M_{201}$ is turned on a short time (e.g., 76 ms) after the battery charger is turned off to bypass the charger to facilitate and make the LED driver ready to run from the battery.
e) The boost LVPS 43 is turned on a short time (e.g., 76 ms) after the battery charger is turned off.
f) A further short time (e.g., 96ms) after the LED driver 33 was turned off, the LED driver 33 is turned on again. The LED driver 33 now runs off the battery.

The period between the switch $M_3$ being turned off and the switch $M_{201}$ turned on (described as 'Zone A' in Figs. 5 and 6), can form the defined time period during with ELCAP $C_{21}$ discharges linearly with a constant current discharge (as can be seen in the first graph of Fig. 5) and its electrical characteristic over time is measured.

For instance, the constant current discharge occurs during the time period marked as 'Zone A', because in this time period the load on the capacitor $C_{21}$ corresponds to the linear regulator input current ($I_{Reg}$) which is essentially the same as the constant load current ($I_{Micro}$) drawn by the microcontroller 32. During this time period, the ELCAP $C_{21}$ voltage can remain above a regulated voltage, of e.g. 3.3 V, which is supplied to the microcontroller 32. Hence, the current drawn by the linear regulator 42 can be the same as the current consumed by the microcontroller 42.

In general, the linear regulator 42 input current $I_{reg}$ can be composed of multiple currents. In the example shown in Fig. 4, it is composed of the current $I_{D1}$ which comes directly from $C_{21}$ and the current $I_{D2}$ which comes from the boost LVPS 43. However, the boost LVPS is kept off during the time period ('Zone A'). Therefore, the contribution of $I_{D2}$ towards the regulator current $I_{Reg}$ is zero during this time period and the microcontroller is only supplied from the ELCAP $C_{21}$ discharge current. For instance, the nominal voltage of $C_{21}$ in mains mode is 8V.

In particular, by discharging the ELCAP $C_{21}$ in a constant current discharge mode, its capacitance can be measured. This can be done by sampling its voltage during the defined time period while knowing its discharge current.

For instance, a typical current drawn from $C_{21}$ during 'Zone A' can be 23.6 mA ($I_{C21\_Typcial}$). For a typical discharge current of 23.6 mA, it may take ca. 64 ms for the capacitor $C_{21}$ voltage to drop by 1 V if the value of capacitance is 1.5 mF. For this drop in voltage, two distinct samples ($V_S$ and $V_F$) of the voltage can be measured. Further the timings of the circuit events mentioned in chronological steps above can be programmed such that the duration of the time period ('Zone A') extends at least in a certain range, of e.g. 100 ms, to provide enough time for the voltage samples to be taken.

A possible procedure to calculate the capacitance of the ELCAP $C_{21}$ is the following:

In a first step, the ELCAP $C_{21}$ discharge current during the defined time period ('Zone A') is determined based on experimentation. Note that since the microcontroller 32 temperature may vary during operation, a correction factor can be introduced as a function of the microcontroller 32 temperature when determining the load current applied to capacitor $C_{21}$ during 'Zone A' ($I_{C21\_compensated}$). For instance, the microcontroller 32 can be capable to read its own temperature for this purpose.

When the function test is requested for the first time after the installation of the LED gear 20, an initial capacitance ($I_{C21\_initial}$) of the ELCAP 21 can be determined. This can be carried out in the following way:

After the switch $M_3$ is turned off, the initial voltage value of capacitor $C_{21}$ is sampled ($V_S$) and the capacitor voltage is allowed to fall linearly by a fixed value (e.g., 1 V or 1,5 V) at which point a second sample is taken ($V_F$). This sampling is shown in the fourth chart in Fig. 6. Further, the time taken for the capacitor voltage to drop by the fixed value is recorded ($\Delta T_{initial}$).

The turn-off of switch M3 can be taken as a reference point to start the sampling the ELCAP $C_{21}$ voltage. Based on the sampled values of the voltages and the predetermined capacitor $C_{21}$ discharge current ($I_{C21\_compensated}$) during the time period ('Zone A'), the initial value of capacitor $C_{21}$ can be calculated by the following formula:

$$C_{21\_initial} = \left(I_{C21\_componesated}\right) \times \frac{(\Delta T_{initial})}{(V_S - V_F)},$$

wherein $C_{21\_initial}$ is the initial value of the capacitance $C_{21}$ (e.g., directly after the LED gear 20 is commissioned) and $\Delta T_{initial}$ is the time taken by the capacitor voltage to fall by the fixed amount (e.g., 1 V) during the first function test. For instance: $(V_s - V_F) = 1$ V.

Calculating the initial capacitance in this way provides a more accurate initial capacitance assessment, compared to using a value from a capacitor datasheet.

Each time a subsequent function test is carried out (e.g., upon a user request), a current value of the capacitance of ELCAP $C_{21}$ is calculated based on the predetermined value of $I_{C21}$ and based on a new time value ($\Delta T_T$), which indicates the time the capacitor requires to fall by the fixed amount (e.g., 1 V), using the following formula:

$$C_{21\_T} = \left(I_{C21\_componesated}\right) \times \frac{(\Delta T_T)}{(V_S - V_F)},$$

wherein $C_{21\_T}$ is the capacitance of ELCAP $C_{21}$ at time 'T'. The change of $C_{21\_T}$ over time (i.e., from measurement to measurement) can be used to predict the end of life of the LED gear 20.

In this way, the capacitance value of the Elcap $C_{21}$ can be calculated every time a function test of the LED gear 20 is carried out and this value can be compared to the initial capacitance value $C_{21\_initial}$ and/or to previously calculated capacitance values. Thereby, the capacitance calculation can be completed in a single step calculation process.

A flag or alarm can be raised when the capacitor approaches or has reached its end of lifetime. For example, the flag or alarm can be raised when the current value of the measured capacitance reaches 20% below the initial capacitance (i.e., when $C_{21T} = 0{,}8 \times C_{21\_initial}$)

The initial value $C_{21\_initial}$ can be stored inside the microprocessor or ASIC memory of the LED gear 20 after the first function test. A current capacitance value $C_{21\_T}$ can be provided to an external device via a DALI or wireless communication, e.g. when requested to be plotted on real time basis on a centralized lifetime analytics dashboard for lifetime monitoring purposes.

As shown in Fig. 4, the LED gear can comprise a plurality of ELCAPs $C_{21}$ and $C_{23}$. The (theoretical predicted) operating hours of these ELCAPs can be different. For instance, ELCAP $C_{21}$ has an expected lifetime of 120k hours and ELCAP $C_{23}$ has an expected lifetime of 52k hours. However, even if ELCAP $C_{23}$ has a shorter expected lifetime than ELCAP 21, ELCAP $C_{21}$ can be chosen for lifetime prediction purposes. Hence, the (end-of-lifetime) flag or alarm can be raised when the capacitance value of $C_{21}$ reduces corresponding to an operating lifetime of 52k hrs, which is approximately 10% down compared to its initial value.

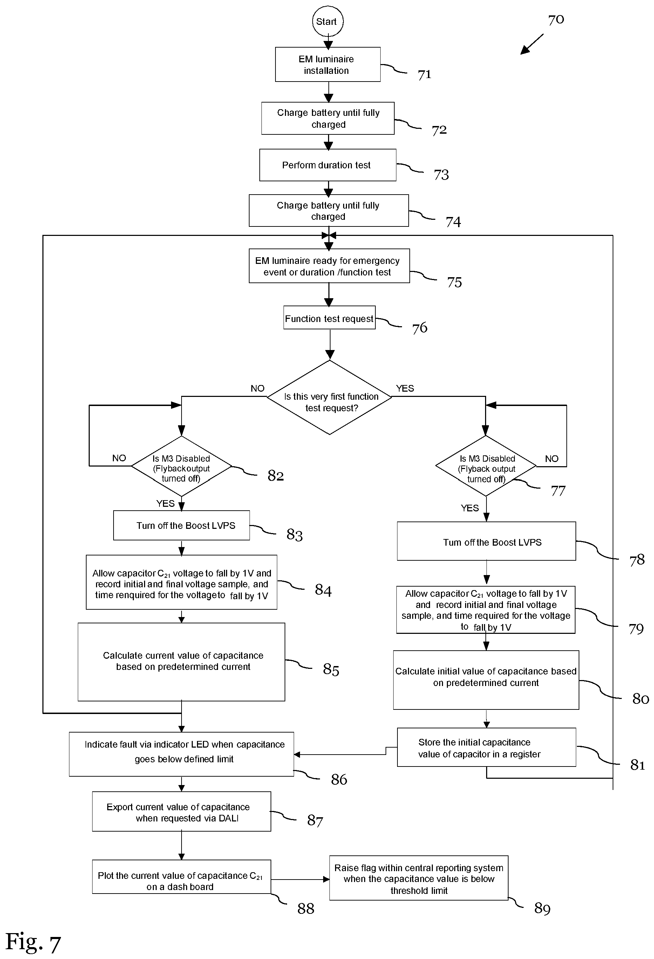

Fig. 7 shows a detailed flow chart of the operating procedure 70 for lifetime prediction of the LED gear 20 during function testing. For instance, the LED gear 20 is an emergency lighting LED driver as shown in Fig. 4, which supplies EM luminaires.

Prior to starting the first function test, EM luminaires which are supplied by the LED gear 20 are installed 71, a battery which is connected to the LED gear is charged 72, and a duration test can be performed 73. After a re-charge of the battery 74, the EM luminaires are ready for operation and for duration/function testing (step 75). Then, a function test can be requested (step 76) .

If this is the first function test, the initial capacitance of the ELCAP $C_{21}$ can be determined. Therefore, as explained above, the switch M3 can be disabled 77 and the boost LVPS can be turned off 78. Then, the ELCAP $C_{21}$ voltage can be allowed to fall by the fixed value (e.g., 1 V) and the initial and final voltage sample ($V_S$ and $V_F$) as well as the time ($\Delta T_{initial}$) that is required until the ELCAP $C_{21}$ falls by the fixed value can be recorded (step 79) .

Subsequently, the initial value of the ELCAP capacitance $C_{21\_initial}$ can be calculated 80 using the above formula. The value of $C_{21\_initial}$ can be stored 81 in a register of the LED gear 20.

If this is not the first function test, the current capacitance of the ELCAP $C_{21}$ can be determined. Therefore, again, the switch M3 can be disabled 82 and the boost LVPS can be turned off 83. Then, the ELCAP $C_{21}$ voltage can be allowed to fall 84 by the fixed value (e.g., 1 V) and the initial and final voltage sample ($V_S$ and $V_F$) as well as the time ($\Delta T_T$) that is required until $C_{21}$ falls by 1V can be recorded (step 79).

Based on these parameters, the current value of the capacitance $C_{21T}$ can be calculated using the above formula 85. If the capacitance value $C_{21T}$ goes below a defined limit compared to $C_{21\_initial}$ an indicator LED can indicate an end of lifetime of the LED gear (step 86).

Further, the current value of the capacitance can be exported (step 87) and the current capacitance value of the ELCAP $C_{21}$ can be plotted on a dashboard (step 88). A flag or alarm can be raised 89 within a central reporting system when the capacitance value is below a threshold limit.

In addition to the initial and current capacitance values, several additional lifetime prediction parameters for the LED gear 20 can be calculated based on the measured/calculated ELCAP capacitance(s). These parameters can comprise:

An ELCAP health data parameter $ECAP_{Health}$, which can be calculated as follows:

$$ECAP_{Health} = 255 \times \left(1 - \frac{C_{int} - C_{measured}}{C_{Tol}}\right)$$

Hereby, $C_{int}$ is the initial capacitance of the capacitor, $C_{measured}$ is a current value of the capacitor and $C_{Tol}$ is a tolerance value (e.g., 10% of the max capacitance). $ECAP_{Health}$ can be a value between 0 and 225 (or a normalized value between 0 and 1), wherein 0 indicates that the ELCAP has reached its end of lifetime.

A parameter $AR_{Average}$ which compares the normalized average aging rate ($DR_{AVG}$) to a nominal estimated rate ($DR_{NOM}$) and can be calculated as follows:

$$AR_{Average} = \frac{DR_{AVG}}{DR_{NOM}}$$

Hereby, $DR_{AVG} = \frac{C_{int} - C_{measured}}{Device\ life\ time\ in\ hrs}$ and $DR_{NOM} = \frac{C_{Tol}}{Device\ life\ time\ in\ hrs}$. For instance, a value of $AR_{Average}$ which is greater than 1.0 indicates that the ELCAP is aging at a rate faster than nominal.

A parameter $AR_{inst}$ which compares a normalized instantaneous aging rate $DR_{INST}$ to the nominal estimate rate and can be calculated as follows:

$$AR_{inst} = \frac{DR_{INST}}{DR_{NOM}}$$

Hereby, $DR_{INST} = \frac{C_{measured(previously)} - C_{measured}}{Interval\ between\ function\ tests\ in\ hours}$. For instance, the parameter $AR_{inst}$ shows if the ELCAP is aging at a rate faster than normal.

A capacitance instantaneous aging rate parameter $CAR_{inst}$ in %-loss per week, which can be calculated as follows:

$$CAR_{inst} = DR_{100} / \left(\frac{Interval\ between\ function\ tests\ in\ hrs}{168}\right).$$

Hereby, $DR_{100} = \frac{(C_{measured(previously)} - C_{measured}) \times 100}{C_{TOL}}$.

A device remaining lifetime parameter $RLT_{INST}$ based on an instantaneous aging rate in hours, which can be calculated as follows:

$$RLT_{INST} = \frac{C_{measured(previously)} - (C_{INT} - C_{TOL})}{DR_{INST}}$$

A device remaining lifetime parameter $RLT_{AVG}$ based on an average aging rate in hours, which can be calculated as follows:

$$RLT_{AVG} = \frac{C_{measured} - (C_{INT} - C_{TOL})}{DR_{AVG}}$$

For instance, each of the parameters $RLT_{INST}$ or $RLT_{AVG}$ can be used as remaining lifetime estimate of the LED gear.

The parameters can further comprise a capacitor average aging rate parameter $CAR_{Avg}$ in %-loss per week, which can be calculated as follows:

$$CAR_{Avg} = DR_{200} / \left( \frac{Device\ lifetimte\ in\ hours}{168} \right)$$

$$DR_{200} = \frac{(C_{INT} - C_{measured}) \times 100}{C_{TOL}}$$

Hereby, .

Each of these parameters (including the values used to calculate these parameters) can be calculated and/or displayed either by the LED gear 20 itself or by an external device which receives the capacitance values from the LED gear 20 (e.g., a central controller or server).

Besides the above approaches, there are other conceivable ways to measure an ELCAP capacitance or to assess the lifetime of an LED gear. However, the possible alternatives listed in the following all suffer from several disadvantages:

For instance, a capacitor that is directly connected after a diode bridge of a LED driver discharges most of the time during normal operation and usually only charges when the mains input voltage is higher than the capacitor voltage itself. In principle, the current during such "normal operation" discharges could be measured with a sensor and the capacitance value could be derived from this current. However, this discharge is typically not linear and depends on the operating conditions of the driver. Thus, it can vary over time. Assuming a certain discharge behavior, e.g. a linear discharge, would therefore introduce errors in the resulting capacitance. Further, an additional current sensor would be required as the discharge current is not known. In addition, the capacitance would be derived from multiple (different) discharges which would make this approach less efficient compared to using a single linear discharge event (e.g., during a function test) according to the above approach.

Alternatively, a test current pulse (e.g., a step load) could be applied to the capacitor, while it is still connected to the AC-DC or DC-DC fronted converter and other loads of the circuit, and the resulting voltage dip across the capacitor could be measured by a sensor. A relative decrease of the capacitance over time could be detected via the strength of this dip. However, in this case the connection to the frontend converter and the other current loads in the circuit arrangement would additionally affect the measurement results. This approach is further less accurate, as it does not allow to directly calculate the capacitance via an observed (linear) voltage drop over time. Instead, it would only allow to assess a relative decreased in capacitance from the strength of the voltage dip.

Further, alternative parameters to the ELCAP capacitance could be used to assess its remaining lifetime. For instance, an impedance or equivalent series resistance of the ELCAP could be measured at specific time intervals over the operating time of the LED gear, and this value could be compared with a predetermined maximum impedance / resistance. However, these parameters are a less suitable for accurately determining the ELCAP health. Further, an additional sensor, e.g. a shunt resistor in series with the ELCAP, would be needed to measure these parameters, e.g., via a ripple current flowing through the ELCAP. This approach would also require additional post processing of the measurement data which introduces further tolerance errors.

Also, the ELCAP temperature during operation can be used to estimate its remaining lifetime. For instance, the ELCAP temperature can be derived from a known control gear temperature (e.g., a temperature of microcontroller or ASIC). However, the formulas which are typically used for such calculations and which are provided by some ELCAP suppliers might not accurately reflect the field operating conditions of the ELCAP. Further, the accuracy of the ELCAP temperature prediction might depend its exact arrangement in the LED gear, in particular its distance to the microcontroller or ASIC.

Although the invention has been illustrated and described with respect to one or more implementations, equivalent alternations and modifications will occur to those skilled in the art upon the reading of the understanding of the specification and the annexed drawings. In addition, while a particular feature of the invention may have been disclosed with respect to only of the several implementations, such features may be combined with one or more other features of the other implementations as may be desired and advantage for any given or particular application.

**Claims**

1. A method (10) for assessing a remaining lifetime of an LED gear (20), preferably an emergency LED gear, the method (10) comprising the steps of:

- supplying (11) a constant current load from an electrolytic capacitor (21) of the LED gear (20;
- measuring (12) an electrical characteristic of the electrolytic capacitor (21) over time when the constant current load is supplied by the electrolytic capacitor (21) ;
- calculating (13) a capacitance of the electrolytic capacitor (21) based on the measured electrical characteristic; and
- determining (15) a remaining lifetime estimate and/or a reaching of an end of lifetime of the LED gear (20) based on the calculated capacitance.

2. The method (10) of claim 1,
wherein the electrical characteristic is a, preferably linear, voltage drop across the electrolytic capacitor (21).

3. The method (10) of claim 2,

wherein the constant current load is supplied from the electrolytic capacitor (21) for a defined time period; and
wherein the capacitance is calculated based on a gradient of the voltage drop during the time period.

4. The method (10) of any one of the preceding claims,
wherein the reaching of the end of lifetime is determined when the calculated capacitance of the electrolytic capacitor (21) falls below a threshold value.

5. The method (10) of any one of the preceding claims,

wherein the constant current load is supplied from the electrolytic capacitor (21) in, preferably regular, time intervals;
wherein, each time the constant current load is supplied from the electrolytic capacitor (21), the electrical characteristic over time of the electrolytic capacitor (21) is measured and a respective capacitance is calculated based on each measured electrical characteristic.

6. The method (10) of claim 5
wherein the remaining lifetime estimate is determined based on a difference of at least two subsequently calculated capacitances.

7. The method (10) of any claim 5 or 6:

- determining (14) an aging rate, in particular an average aging rate, of the electrolytic capacitor (21) based on a change of the calculated capacitances over time.

8. The method (10) of any one of the preceding claims,
wherein the constant current load is supplied from the electrolytic capacitor (21) each time a function test of the LED gear (20) is carried out.

9. The method (10) of claim 8,
wherein, during the function test, the step of measuring (12) the electrical characteristic of the electrolytic capacitor (21) is carried out after disconnecting the PFC (41) supply to the LED gear (20) and prior to powering connected LEDs of a battery of the LED gear (20).

10. The method (10) of any one of the preceding claims,
wherein during the measurement of the electrical characteristic, the constant current load is the only current load supplied by the electrolytic capacitor (21).

11. The method (10) of any one of the preceding claims,
wherein the constant current load is a microcontroller (32) of the LED gear (20).

12. An LED gear (20), in particular an emergency LED lighting driver, comprising:

an electrolytic capacitor (21) which is configured to supply a constant current load; and
a controller (22) which is configured to measure an electrical characteristic of the electrolytic capacitor (21) over time when the constant current load is supplied by the electrolytic capacitor (21);

wherein the controller (22) is configured to calculate a capacitance of the electrolytic capacitor (21) based on the measured electrical characteristic; and

wherein the controller (22) is configured to determine a remaining lifetime estimate and/or a reaching of an end of lifetime of the LED gear (20) based on the calculated capacitance.

13. The LED gear (20) of claim 12, further comprising:
   an optical indicator (25) which is configured to display a signal when the reaching of the end of lifetime is detected.

14. The LED gear (20) of claim 12 or 13,
   wherein the constant current load is a microcontroller (32) of the LED gear (20).

15. The LED gear (20) of any one of claims 12 to 14, further comprising:
   an interface (24) configured to output the calculated capacitance and/or the determined remaining lifetime estimate.

10

```
┌─────────────────────────────────────────────┐
│          Supply a constant current            │    11
└─────────────────────────────────────────────┘
                      │
                      ▼
┌─────────────────────────────────────────────┐
│       Measuring an electrical characteristic  │    12
└─────────────────────────────────────────────┘
                      │
                      ▼
┌─────────────────────────────────────────────┐
│       Calculating a capacitance of the ELcap  │    13
└─────────────────────────────────────────────┘
                      │
                      ▼
┌─────────────────────────────────────────────┐
│          Determining an aging rate            │    14
└─────────────────────────────────────────────┘
                      │
                      ▼
┌─────────────────────────────────────────────┐
│  Determining remaining lifetime estimate / end of │
│                   lifetime                    │    15
└─────────────────────────────────────────────┘
```

Fig. 1

Fig. 2

Fig. 3

Fig. 4

Fig. 5

Fig. 6

Fig. 7

```
                              ( Start )
                                  │
                                  ▼
                        ┌──────────────────┐
                        │   EM luminaire    │
                        │   installation    │──── 71
                        └──────────────────┘
                                  │
                                  ▼
                        ┌──────────────────┐
                        │ Charge battery    │
                        │ until fully       │──── 72
                        │ charged           │
                        └──────────────────┘
                                  │
                                  ▼
                        ┌──────────────────┐
                        │ Perform duration  │──── 73
                        │ test              │
                        └──────────────────┘
                                  │
                                  ▼
                        ┌──────────────────┐
                        │ Charge battery    │
                        │ until fully       │──── 74
                        │ charged           │
                        └──────────────────┘
```

70

```
                        ┌──────────────────────────┐
                        │ EM luminaire ready for     │
                        │ emergency event or         │──── 75
                        │ duration /function test    │
                        └──────────────────────────┘
                                  │
                                  ▼
                        ┌──────────────────┐
                        │ Function test     │──── 76
                        │ request           │
                        └──────────────────┘
                                  │
                                  ▼
              NO          ◇ Is this very first        YES
         ┌───────────────   function test request? ───────────────┐
         │                                                         │
         ▼                                                         ▼
   NO  ◇ Is M3 Disabled                          ◇ Is M3 Disabled   NO
  ┌──── (Flyback output ──── 82              ──── (Flyback output ──── 77
  │      turned off)                              turned off)
  │       │ YES                                    │ YES
  │       ▼                                         ▼
  │  ┌──────────────────┐                    ┌──────────────────┐
  │  │ Turn off the      │──── 83             │ Turn off the      │──── 78
  │  │ Boost LVPS        │                    │ Boost LVPS        │
  │  └──────────────────┘                    └──────────────────┘
```

Allow capacitor $C_{21}$ voltage to fall by 1V and record initial and final voltage sample, and time renquired for the voltage to fall by 1V —— 84

Calculate current value of capacitance based on predetermined current —— 85

Allow capacitor $C_{21}$ voltage to fall by 1V and record initial and final voltage sample, and time required for the voltage to fall by 1V —— 79

Calculate initial value of capacitance based on predetermined current —— 80

Store the initial capacitance value of capacitor in a register —— 81

Indicate fault via indicator LED when capacitance goes below defined limit —— 86

Export current value of capacitance when requested via DALI —— 87

Plot the current value of capacitance $C_{21}$ on a dash board —— 88

Raise flag within central reporting system when the capacitance value is below threshold limit —— 89

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/368204 A1 (SIESSEGGER BERNHARD [US] ET AL) 18 December 2014 (2014-12-18) | 1,4,7,8, 11-15 | INV. G01R31/64 |
| Y | * paragraphs [0002], [0011] – paragraph [0013]; figures 1a,1b,5 * <br> * paragraph [0021] – paragraph [0026] * <br> * paragraph [0031] – paragraph [0039] * <br> ----- | 2-6,9,10 | G01R27/26 <br><br> ADD. G01R31/26 G01R31/40 |
| X | US 2015/340882 A1 (GÖTH FREDRIK [SE]) 26 November 2015 (2015-11-26) | 1-3,5,12 | G01R31/44 H05B45/30 |
| Y | * paragraph [0016] – paragraphs [0018], [0068]; figures 5a,5b,7 * <br> ----- | 2,3,5 | H05B45/50 H02J9/06 H05B47/17 |
| X | US 2015/130273 A1 (GOVINDARAJ ARVIND [US] ET AL) 14 May 2015 (2015-05-14) | 1,4,6,9, 10,12 | |
| Y | * paragraphs [0004], [0008], [0009], [0024], [0025], [0029]; claim 1; figures 3,5 * <br> ----- | 4,6,9,10 | |

TECHNICAL FIELDS SEARCHED (IPC)

G01R
H05B

The present search report has been drawn up for all claims

| Place of search | Date of completion of the search | Examiner |
|---|---|---|
| Munich | 12 January 2024 | Hof, Klaus-Dieter |

EPO FORM 1503 03.82 (P04C01)

## ANNEX TO THE EUROPEAN SEARCH REPORT
## ON EUROPEAN PATENT APPLICATION NO.

**EP 23 19 1228**

This annex lists the patent family members relating to the patent documents cited in the above-mentioned European search report.
The members are as contained in the European Patent Office EDP file on
The European Patent Office is in no way liable for these particulars which are merely given for the purpose of information.

**12-01-2024**

| Patent document cited in search report | | | Publication date | Patent family member(s) | | | Publication date |
|---|---|---|---|---|---|---|---|
| US 2014368204 | A1 | | 18-12-2014 | CN | 104322144 | A | 28-01-2015 |
| | | | | EP | 2805571 | A1 | 26-11-2014 |
| | | | | KR | 20140114889 | A | 29-09-2014 |
| | | | | KR | 20170086687 | A | 26-07-2017 |
| | | | | US | 2014368204 | A1 | 18-12-2014 |
| | | | | WO | 2013110027 | A1 | 25-07-2013 |
| US 2015340882 | A1 | | 26-11-2015 | AU | 2012366914 | A1 | 10-07-2014 |
| | | | | CN | 104054233 | A | 17-09-2014 |
| | | | | EP | 2805401 | A1 | 26-11-2014 |
| | | | | US | 2015340882 | A1 | 26-11-2015 |
| | | | | WO | 2013107497 | A1 | 25-07-2013 |
| US 2015130273 | A1 | | 14-05-2015 | DE | 102014222681 | A1 | 13-05-2015 |
| | | | | US | 2015130273 | A1 | 14-05-2015 |

EPO FORM P0459